# EUROPÄISCHE PATENTSCHRIFT

(11) **EP 3 665 870 B1**
(45) Veröffentlichungstag und Bekanntmachung des Hinweises auf die Patenterteilung: **21.07.2021**
(21) Anmeldenummer: 18749364.8
(22) Anmeldetag: 01.08.2018
(51) Int. Cl.: H04L 12/40, H03K 5/1534, H04B 3/20, H04L 25/02, H04L 25/03

(54) **SENDE-/EMPFANGSEINRICHTUNG FÜR EIN BUSSYSTEM ZUR REDUZIERUNG EINER SCHWINGNEIGUNG BEIM ÜBERGANG ZWISCHEN UNTERSCHIEDLICHEN BITZUSTÄNDEN**
TRANSCEIVER FOR A BUS SYSTEM FOR REDUCING AN OSCILLATION INCLINATION UPON TRANSITIONING BETWEEN DIFFERENT BIT STATE
DISPOSITIF D'ÉMISSION / RÉCEPTION POUR UN SYSTÈME DE BUS DE RÉDUCTION D'UNE DISPOSITION AUX OSCILLATIONS LORS DE LA TRANSITION ENTRE DIFFÉRENTS ÉTATS BINAIRES

(30) Priorität: 08.08.2017 DE 102017213833
(43) Veröffentlichungstag der Anmeldung: 17.06.2020
(73) Patentinhaber: Robert Bosch GmbH, 70442 Stuttgart (DE)
(72) Erfinder: WALKER, Steffen, 72770 Reutlingen (DE); PANNWITZ, Axel, 01445 Radebeul (DE); BRANDO, Cyrille, 72654 Neckartenzlingen (DE)
(86) Internationale Anmeldenummer: PCT/EP2018/070909
(87) Internationale Veröffentlichungsnummer: WO 2019/030080

(56) Entgegenhaltungen:
- EP-A2- 2 660 974
- WO-A1-2015/014550
- DE-A1-102010 043 484
- US-A1- 2014 156 893

## Beschreibung

Die vorliegende Erfindung betrifft eine Sende-/Empfangseinrichtung für ein Bussystem und ein Verfahren zur Reduzierung einer Schwingneigung beim Übergang zwischen unterschiedlichen Bitzuständen, welche beispielsweise bei einer Teilnehmerstation für ein CAN-Bussystem zum Einsatz kommen können. Die Reduzierung der Schwingneigung wird durch zusätzliche Treiber an Busadern eines Busses des Bussystems erzielt.

### Stand der Technik

Bei einer Nachrichten- oder Datenübertragung in einem Bussystem werden Informationen, die in Bytes bzw. Bits der Nachrichten oder Daten enthalten sind, durch unterschiedliche Bitzustände oder Spannungszustände dargestellt. Die unterschiedlichen Bitzustände haben beim Übertragen der Nachricht über einen Bus des Bussystems unterschiedliche Buszustände zur Folge. Je nach Bussystem existieren für Nachrichten- oder Datenübertragung verschiedene Übertragungsprotokolle.

Beispielsweise werden beim CAN-Bussystem Nachrichten mittels des CAN- und/oder CAN FD Protokolls übertragen, wie es im Standard ISO-11898-1:2015 als CAN Protokoll-Spezifikation mit CAN FD beschrieben ist. Das CAN-Bussystem ist heute für die Kommunikation zwischen Sensoren und Steuergeräten weit verbreitet. Oft wird das CAN-Bussystem in Fahrzeugen oder Automatisierungsanlagen, usw. für eine Kommunikation zwischen den einzelnen Busteilnehmern eingesetzt.

Insbesondere bei der CAN/CAN-FD-Kommunikation müssen die Sende-/Empfangseinrichtungen, die auch Transceiver genannt werden, in der Lage sein, den Bus niederohmig treiben zu können, um einen dominanten Buszustand oder Bitzustand als einen der beiden verschiedenen Buszustände oder Bitzustände herzustellen. Im Rezessivzustand als dem anderen der beiden verschiedenen Buszustände dagegen sind die Sende-/Empfangseinrichtungen verhältnismäßig hochohmig.

Der Übergang von Dominant nach Rezessiv ist je nach Bustopologie, Länge der Stubs bzw. Stichleitungen, Position und Anzahl der Terminationswiderstände mit einer Schwingneigung behaftet. Dies ist sehr unvorteilhaft bei der Systemauslegung, weil infolgedessen die Bitzeit so lang sein muss, bis die Schwingung ausreichend bedämpft ist. Ist die Bitzeit nicht lang genug, kann die Sende-/Empfangseinrichtung im Rezessivzustand fälschlicherweise ein Dominant erkennen. Daher bedingt eine Einhaltung der maximal zulässigen Fehlerquote der Sende-/Empfangseinrichtung eine längere Bitzeit, was eine unerwünschte Reduzierung der Übertragungsrate oder Übertragungsgeschwindigkeit der Nachrichten im Bussystem zur Folge hat.

Die Offenlegungsschrift DE 10 2010 043484 A1 offenbart eine Sende-/Empfangseinrichtung für ein Bussystem, welche Mittel umfasst, um zumindest bei Vorliegen einer vorgebbaren oder vorgegebenen Umschaltbedingung die Einstellung mindestens eines der Buspegel durch Treiben mindestens eines geeigneten weiteren elektrischen Stromes zu beschleunigen.

Das Dokument US 2014/156893 A1 offenbart eine Sende-/Empfangseinrichtung für ein Bussystem, bei der ein dominant-nach-rezessiv-Übergang erkannt wird und mittels einer geeigneten Treiberstufe das Einstellen des rezessiven Buszustands optimiert werden kann.

Das Dokument WO 2015/014550 A1 offenbart eine Sende-/Empfangseinrichtung für ein Bussystem, bei der mittels einer geeigneten Treiberstufe eine Vorverzerrung des Ausgangssignals in bestimmten Abschnitten einer übertragenen Nachricht durchgeführt wird.

EP 2 660 974 A2 offenbart eine Sende-/Empfangseinrichtung für ein Bussystem, bei der durch Verwendung unterschiedlicher Sendeschaltungen in einem ersten und einem zweiten Übertragungsmodus die Übertragung in bestimmten Abschnitten einer Nachricht optimiert wird.

### Offenbarung der Erfindung

Daher ist es Aufgabe der vorliegenden Erfindung, eine Sende-/Empfangseinrichtung für ein Bussystem und ein Verfahren zur Reduzierung einer Schwingneigung beim Übergang zwischen unterschiedlichen Bitzuständen bereitzustellen, welche die zuvor genannten Probleme lösen. Insbesondere sollen eine Sende-/Empfangseinrichtung für ein Bussystem und ein Verfahren zur Reduzierung einer Schwingneigung beim Übergang zwischen unterschiedlichen Bitzuständen oder Spannungszuständen, insbesondere einer Schwingneigung beim Übergang vom dominanten zum rezessiven Zustand, in einem Bussystem bereitgestellt werden.

Der Schutzumfang der Erfindung wird durch die beigefügten Ansprüche definiert.

Mit der beschriebenen Sende-/Empfangseinrichtung ist eine Reduzierung der Schwingdauer oder ein sogenanntes Ringing Suppression beim Übergang von Dominant nach Rezessiv möglich, woraus eine Erhöhung der Bitraten folgt, insbesondere im Datenbereich einer Nachricht. Als Folge davon steigt die Übertragungsrate oder Übertragungsgeschwindigkeit der Nachrichten im Bussystem.

Zudem erlaubt eine Reduzierung der Schwingdauer beim Übergang zwischen unterschiedlichen Bitzuständen oder Spannungszuständen, insbesondere beim CAN-Bussystem von Dominant nach Rezessiv, mehr Freiheit bei der Auslegung von Bustopologien und/oder von Abschlüssen und/oder von Stubs und/oder von der Anzahl der Knoten bzw. Teilnehmerstationen des Bussystems.

Noch dazu wird durch die beschriebene Ausgestaltung der Sende-/Empfangseinrichtung eine vorteilhafte Veränderung des Spektrums bei leitungsgebundener Emission erzielt. Die Abstrahlung von Emissionen kann nämlich im kritischen Frequenzbereich verringert werden, der beispielsweise zwischen ca. ein und ca. drei MHz liegt, was der Resonanzfrequenz aus Gleichtaktdrossel und parasitären Kapazitäten entspricht. Stattdessen tritt durch die beschriebene Sende-/Empfangseinrichtung die Abstrahlung von Emissionen in dem unkritischen Frequenzbereich auf, der bei dem genannten Beispiel bei Frequenzen größer ca. 10 MHz liegt, und bei dem die Drossel wirkt.

Darüber hinaus wird eine sehr symmetrische Impedanz der beiden Busadern des Busses durch die hinzugefügten Treiber geschaffen. Bei der beschriebenen Sende-/Empfangseinrichtung sind an jeder Busader nun die gleichen Elemente angeschlossen. Dadurch wird die Störfestigkeit und Emission der Sende-/Empfangseinrichtung und der Komponenten erhöht, die mit der Sende-/Empfangseinrichtung verbunden sind.

Die Sende-/Empfangseinrichtung ist für alle Kommunikationssysteme geeignet, bei welchen ein Buszustand aktiv getrieben wird, wie insbesondere bei einem CAN-Bussystem, einem CAN-HS-Bussystem, einem CAN-FD-Bussystem, usw. Bei einem CAN-HS-Bussystem (HS = Hochgeschwindigkeit = Highspeed) ist eine Datenübertragungsrate von bis zu 500 kBit pro Sekunde (500 kbps) möglich. Bei einem CAN FD-Bussystem ist eine Datenübertragungsrate von größer 1 MBit pro Sekunde (1Mbps) möglich.

### Zeichnungen

Nachfolgend ist die Erfindung unter Bezugnahme auf die beiliegende Zeichnung und anhand von Ausführungsbeispielen näher beschrieben. Es zeigen:
Fig. 1 ein vereinfachtes Blockschaltbild eines Bussystems gemäß einem ersten Ausführungsbeispiel;
Fig. 2 ein elektrisches Schaltbild einer Sende-/Empfangseinrichtung des Bussystems gemäß dem ersten Ausführungsbeispiel;
Fig. 3A einen zeitlichen Verlauf eines Sendesignals TxD bei der Sende-/Empfangseinrichtung gemäß dem ersten Ausführungsbeispiel sowie Fig. 3B einen zeitlichen Verlauf eines Sendesignals TxD bei einer herkömmlichen Sende-/Empfangseinrichtung;
Fig. 4A einen zeitlichen Verlauf der Bussignale CAN_H und CAN_L bei der Sende-/Empfangseinrichtung gemäß dem ersten Ausführungsbeispiel sowie Fig. 4B einen zeitlichen Verlauf der Bussignale CAN_H und CAN_L bei der herkömmlichen Sende-/Empfangseinrichtung;
Fig. 5A einen zeitlichen Verlauf einer Differenzspannung VDIFF der Bussignale CAN_H und CAN_L bei der Sende-/Empfangseinrichtung gemäß dem ersten Ausführungsbeispiel sowie Fig. 5B einen zeitlichen Verlauf der Differenzspannung VDIFF der Bussignale CAN_H und CAN_L bei der herkömmlichen Sende-/Empfangseinrichtung;
Fig. 6A einen zeitlichen Verlauf einer Empfängerausgabe bei der Sende-/Empfangseinrichtung gemäß dem ersten Ausführungsbeispiel sowie Fig. 6B einen zeitlichen Verlauf einer Empfängerausgabe bei der herkömmlichen Sende-/Empfangseinrichtung;
Fig. 7A einen zeitlichen Verlauf eines Empfangssignals RxD bei der Sende-/Empfangseinrichtung gemäß dem ersten Ausführungsbeispiel sowie Fig. 7B einen zeitlichen Verlauf eines Empfangssignals RxD bei einer herkömmlichen Sende-/Empfangseinrichtung;
Fig. 8 ein elektrisches Schaltbild einer Sende-/Empfangseinrichtung des Bussystems gemäß einer Modifikation des ersten Ausführungsbeispiels;
Fig. 9 ein Schaubild zur Veranschaulichung des Aufbaus einer Nachricht, die von einer Teilnehmerstation des Bussystems gemäß dem ersten Ausführungsbeispiel gesendet wird;
Fig. 10 ein elektrisches Schaltbild einer Sende-/Empfangseinrichtung eines Bussystems gemäß einem zweiten Ausführungsbeispiel; und
Fig. 11 ein elektrisches Schaltbild einer Sende-/Empfangseinrichtung eines Bussystems gemäß einem dritten Ausführungsbeispiel.

In den Figuren sind gleiche oder funktionsgleiche Elemente, sofern nichts anderes angegeben ist, mit denselben Bezugszeichen versehen.

### Beschreibung der Ausführungsbeispiele

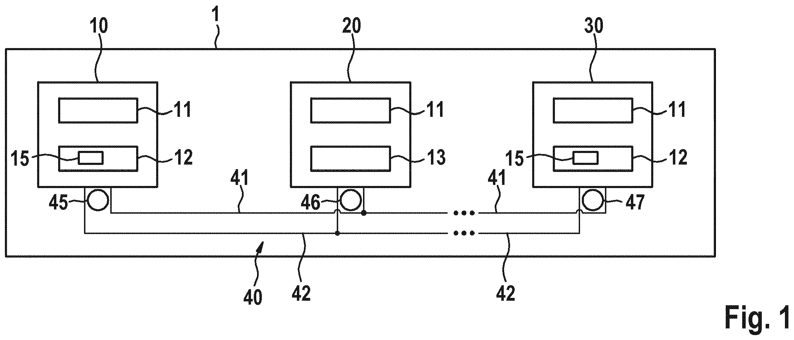

Fig. 1 zeigt ein Bussystem 1, das beispielsweise zumindest abschnittsweise ein CAN-Bussystem, ein CAN-FD-Bussystem, usw., sein kann. Das Bussystem 1 kann in einem Fahrzeug, insbesondere einem Kraftfahrzeug, einem Flugzeug, usw., oder im Krankenhaus usw. Verwendung finden.

In Fig. 1 hat das Bussystem 1 eine Vielzahl von Teilnehmerstationen 10, 20, 30, die jeweils an einen Bus 40 mit einer ersten Busader 41 und einer zweiten Busader 42 angeschlossen sind. Die Busadern 41, 42 können auch CAN_H und CAN_L genannt werden und dienen zur elektrischen Signalübertragung nach Einkopplung der dominanten Pegel bzw. Erzeugung von rezessiven Pegeln für ein Signal im Sendezustand. Über den Bus 40 können Nachrichten 45, 46, 47 in der Form von Signalen zwischen den einzelnen Teilnehmerstationen 10, 20, 30 übertragen werden. Die Teilnehmerstationen 10, 20, 30 können beispielsweise Steuergeräte oder Anzeigevorrichtungen eines Kraftfahrzeugs sein.

Wie in Fig. 1 gezeigt, haben die Teilnehmerstationen 10, 30 jeweils eine Kommunikationssteuereinrichtung 11 und eine Sende-/Empfangseinrichtung 12. Die Sende-/Empfangseinrichtungen 12 umfassen jeweils eine Schwingungsreduktionseinheit 15. Die Teilnehmerstation 20 hat dagegen eine Kommunikationssteuereinrichtung 11 und eine Sende-/Empfangseinrichtung 13. Die Sende-/Empfangseinrichtungen 12 der Teilnehmerstationen 10, 30 und die Sende-/Empfangseinrichtung 13 der Teilnehmerstation 20 sind jeweils direkt an den Bus 40 angeschlossen, auch wenn dies in Fig. 1 nicht dargestellt ist.

Die Kommunikationssteuereinrichtung 11 dient zur Steuerung einer Kommunikation der jeweiligen Teilnehmerstation 10, 20, 30 über den Bus 40 mit einer anderen Teilnehmerstation der an den Bus 40 angeschlossenen Teilnehmerstationen 10, 20, 30. Die Sende-/Empfangseinrichtung 12 dient zum Senden der Nachrichten 45, 47 in Form von Signalen und nutzt hierbei die Schwingungsreduktionseinheit 15, wie später noch ausführlicher beschrieben. Die Kommunikationssteuereinrichtung 11 kann insbesondere wie ein herkömmlicher CAN-FD-Controller und/oder CAN-Controller ausgeführt sein. Die Sende-/Empfangseinrichtung 13 kann insbesondere wie ein herkömmlicher CAN-Transceiver und/oder CAN-FD-Transceiver ausgeführt sein. Die Sende-/Empfangseinrichtung 13 kann insbesondere wie ein herkömmlicher CAN-Transceiver ausgeführt sein.

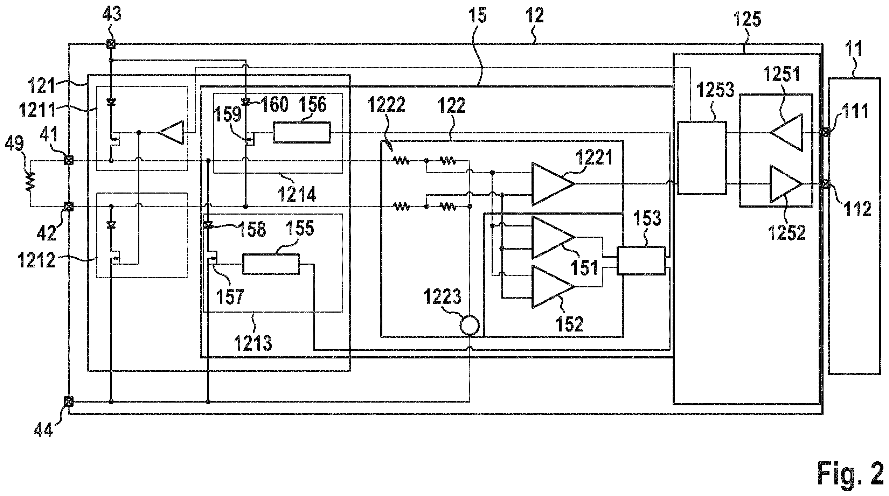

Fig. 2 zeigt den grundlegenden Aufbau der Sende-/Empfangseinrichtung 12 mit der Schwingungsreduktionseinheit 15. Die Sende-/Empfangseinrichtung 12 ist an den Bus 40, genauer gesagt dessen erste Busader 41 für CAN_H und dessen zweite Busader 42 für CAN_L angeschlossen. Die Spannungsversorgung, insbesondere CAN-Supply, für die erste und zweite Busader 41, 42 erfolgt über einen Anschluss 43. Der Anschluss an Masse bzw. CAN_GND ist über einen Anschluss 44 realisiert. Die erste und zweite Busader 41, 42 sind mit einem Abschlusswiderstand 49 terminiert.

Die erste und zweite Busader 41, 42 sind in der Sende-/Empfangseinrichtung 12 mit einem Sender 121, der auch als Transmitter bezeichnet wird, und mit einem Empfänger 122 verbunden, der auch als Receiver bezeichnet wird. Sowohl mit dem Sender 121 als auch dem Empfänger 122 ist eine Anschalteinheit 125 zum Treiben von Signalen über die Anschlüsse 111, 112 an die Kommunikationssteuereinrichtung 11 verbunden.

Zum Treiben der Signale der Anschlüsse 111, 112 hat die Anschalteinheit 125 einen Sendesignaltreiber 1251 für ein Sendesignal TxD, das auch als TxD-Signal bezeichnet wird und an dem Anschluss 111 von der Kommunikationssteuereinrichtung 11 empfangen wird. Zudem hat die Anschalteinheit 125 einen Empfangssignaltreiber 1252 für ein Empfangssignal RxD, das auch als RxD-Signal bezeichnet wird, von den Busadern 41, 42 mittels des Empfängers 122 empfangen wurde und über den Anschluss 112 an die Kommunikationssteuereinrichtung 11 weitergegeben wird. Die Treiber 1251, 1252 sind über ein Digitalteil 1253 mit dem Sender 121 und dem Empfänger 122 verbunden. Das Digitalteil 1253 kann eine Überwachung der Signale TxD, RxD durchführen.

Gemäß Fig. 2 sind Komponenten der Schwingungsreduktionseinheit 15 in den Sender 121 eingebaut. Weitere Komponenten der Schwingungsreduktionseinheit 15 sind in den Empfänger 122 eingebaut. Hierbei hat der Sender 121 zusätzlich zu einem Treiber 1211 mit Treiberschaltung und einer ersten Endstufe aus Transistor und Diode für die erste Busader 41 und einem Treiber 1212 mit der Treiberschaltung und einer zweiten Endstufe aus Transistor und Diode für die zweite Busader 42 eine Treibernachbildung 1213 für die erste Busader 41 und eine Treibernachbildung 1214 für die zweite Busader 42. Der Treiber 1211 kann bei dem vorliegenden Ausführungsbeispiel auch als CAN_H-Treiber 1211 eines herkömmlichen Senders bezeichnet werden. Der Treiber 1212, der ebenfalls mit der bei dem Treiber 1211 dargestellten Treiberschaltung angesteuert wird, kann bei dem vorliegenden Ausführungsbeispiel auch als CAN_L-Treiber 1212 eines herkömmlichen Senders bezeichnet werden. Die Treibernachbildung 1213 ist somit bei dem vorliegenden Ausführungsbeispiel für CAN_H vorgesehen. Die Treibernachbildung 1214 ist somit bei dem vorliegenden Ausführungsbeispiel für CAN_L vorgesehen. Die Treibernachbildungen 1213, 1214 sind auch Komponenten der Schwingungsreduktionseinheit 15. Die Treibernachbildungen 1213, 1214 sind auch Komponenten der Schwingungsreduktionseinheit 15.

Der Empfänger 122 hat einen Empfangskomparator 1221, dessen Eingang in einem resistiven, insbesondere symmetrischen, Spannungsteiler 1222, genauer gesagt dessen Mittelabgriff, verschaltet ist, und eine Busvorspannungseinheit 1223. Die Busvorspannungseinheit 1223 speist den resistiven Spannungsteiler 1222 an seinem einen Ende mit einer vorbestimmten Busvorspannung oder einem vorbestimmten Busvorspannungspotenzial. Der resistive Spannungsteiler 1222 ist an seinem anderen Ende an die erste und zweite Busader 41, 42 angeschlossen. Der Eingang des Empfangskomparators 1221 ist mit der Schwingungsreduktionseinheit 15 verschaltet, wie nachfolgend ausgeführt.

Die Schwingungsreduktionseinheit 15 umfasst einen Zustandswechsel-Erfassungsblock 151 und einen Kommunikationsphasen-Erfassungsblock 152. Die Eingänge der Blöcke 151, 152 sind jeweils parallel zu dem Eingang des Empfangskomparators 1221 geschaltet. Die Ausgänge der Blöcke 151, 152 sind an einen RS-Zeitsteuerungsblock 153 angeschlossen bzw. mit dem RS-Zeitsteuerungsblock 153 verbunden. Der Block 153 dient zur Steuerung des Signals auf der ersten Busader 41 bzw. CAN_H und/oder des Signals auf der zweiten Busader 42 bzw. CAN_L, wie nachfolgend noch genauer beschrieben. Die Blöcke 151, 152, 153 sind Komponenten Schwingungsreduktionseinheit 15 und des Empfängers 122.

In Bezug auf die Treibernachbildungen 1213, 1214 umfasst die Schwingungsreduktionseinheit 15 einen ersten RS-Treiber 155 und einen zweiten RS-Treiber 156, sowie Transistoren 157, 159 und Dioden 158, 160. Der erste RS-Treiber 155 bildet zusammen mit dem Transistor 157 und der Diode 158 die Treibernachbildung 1213 für das Signal CAN_H. Der zweite RS-Treiber 156 bildet zusammen mit dem Transistor 159 und der Diode 160 die Treibernachbildung 1214 für CAN_L. Die Transistoren 157, 159 können als Hochvolt-Schalter ausgeführt sein. Alternativ können die Transistoren 157, 159 jeweils als eine Serienschaltung von Niedervolt-Schalttransistor und Hochvolt-Kaskode ausgeführt sein. Kaskoden haben immer ein festes Gatepotential und schalten nicht, sie schirmen nur die Hochspannung ab. Der Transistor 157 umfasst beispielsweise eine Hochvolt-NMOS-Kaskode. Der Transistor 159 umfasst beispielsweise eine Hochvolt-PMOS-Kaskode.

Gemäß Fig. 2 ist der RS-Zeitsteuerungsblock 153 jeweils an seinem Ausgang an die CAN_H_RS-Treiber 155 und CAN_L_RS-Treiber 156 angeschlossen bzw. mit diesen verbunden. Der erste RSTreiber 155 ist an seinem Ausgang mit dem Gate-Anschluss des Transistors 157 verbunden. Der Source-Anschluss des Transistors 157 ist über den Anschluss 44 an Masse bzw. CAN_GND angeschlossen. Der Drain-Anschluss des Transistors 157 ist mit der Kathode der Diode 158 verbunden. Die Anode der Diode 158 ist mit der ersten Busader 41, also CAN_H, verbunden.

Außerdem ist der zweite RS-Treiber 156 an seinem Ausgang mit dem Gate-Anschluss des Transistors 159 verbunden. Der Drain-Anschluss des Transistors 159 ist mit der zweiten Busader 42, also CAN_L verbunden. Der Source-Anschluss des Transistors 159 ist mit der Kathode der Diode 160 verbunden. Die Anode der Diode 160 ist über den Anschluss 43 an die Spannungsversorgung bzw. CAN_SUPPLY angeschlossen.

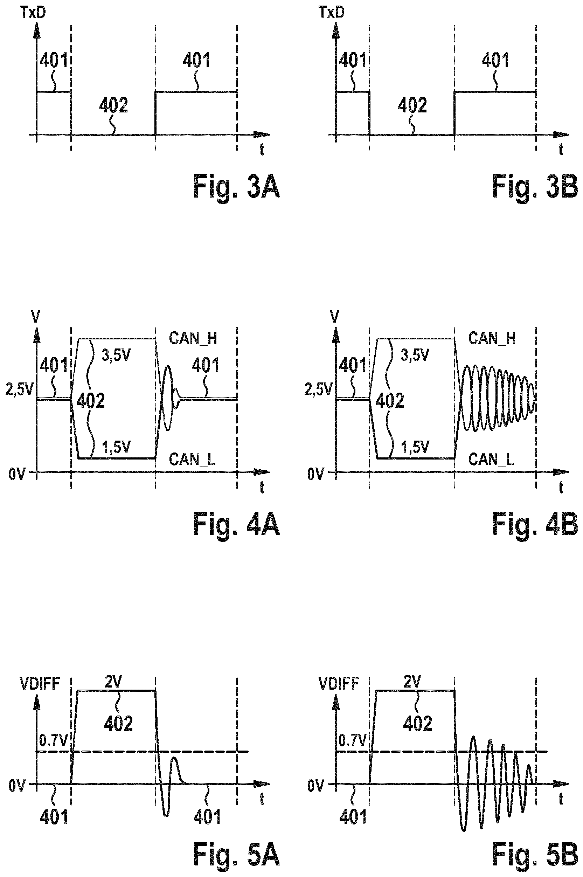

Der Betrieb der Sende-/Empfangseinrichtung 12 gemäß Fig. 2 ist nachfolgend auch anhand der Signalverläufe von Fig. 3A bis Fig. 7B näher erläutert.

Fig. 3A bis Fig. 7A zeigen jeweils einen zeitlichen Verlauf von Signalen bei der Sende-/Empfangseinrichtung 12 gemäß dem vorliegenden Ausführungsbeispiel. Hierbei stellen sich in Folge eines in Fig. 3A gezeigten Sendesignals TxD die Signale gemäß Fig. 4A bis Fig. 7A ein.

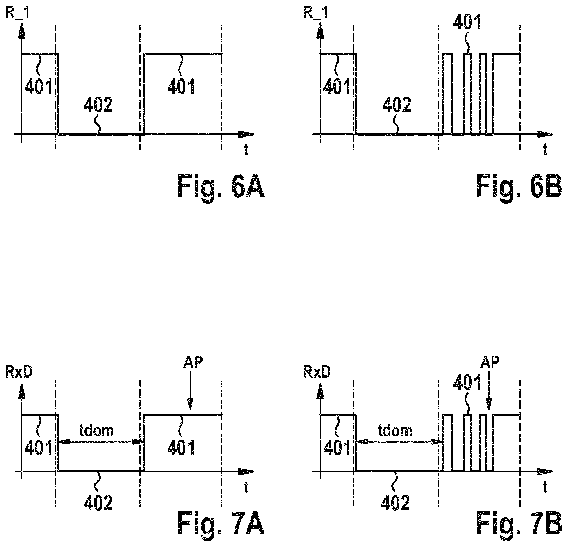

Bei dem Sendesignal TxD von Fig. 3A findet im Laufe der Zeit t bei drei aufeinanderfolgenden Bits ein Zustandswechsel von einem ersten Buszustand 401 zu einem zweiten Buszustand 402 und dann wieder zurück zu dem ersten Buszustand 401 statt. Der erste Buszustand 401 kann auch als Rezessivzustand oder hoher Pegel bezeichnet werden. Der zweite Buszustand 402 kann auch als Dominantzustand oder niedriger Pegel bezeichnet werden. In Folge des Sendesignals TxD von Fig. 3A stellt sich die Spannung V für die Signale CAN_H und CAN_L gemäß Fig. 4A ein, die Differenzspannung VDIFF = CAN_H - CAN_L gemäß Fig. 5A ein, ein Ausgangssignal R_1 des Empfängers 122 gemäß Fig. 6A ein, und ein Empfangssignal RxD gemäß Fig. 7A ein. Die Spannung V für die Signale CAN_H und CAN_L gemäß Fig. 4A entspricht im ersten Buszustand 401 oder rezessiven Zustand der Hälfte des Busvorspannungspotenzials der Busvorspannungseinheit 1223.

Im Vergleich dazu sind in den Fig. 3B bis Fig. 7B jeweils die zeitlichen Verläufe von Signalen bei einer Sende-/Empfangseinrichtung gemäß einer herkömmlichen Sende-/Empfangseinrichtung veranschaulicht, wie beispielsweise der Sende-/Empfangseinrichtung 13 der Teilnehmerstation 20.

Aus dem Vergleich der Signale von Fig. 4A und Fig. 4B ergibt sich sehr deutlich, dass die Sende-/Empfangseinrichtung 12 gemäß dem vorliegenden Ausführungsbeispiel bei demselben Sendesignal TxD ein deutlich schnelleres Einschwingen der Signale CAN-H und CAN_L nach dem Zustandswechsel von dem Zustand 401 auf den Zustand 402 bzw. von Dominant nach Rezessiv bewirkt. Ist die Schwellwertspannung des Empfängers 122 auf den üblichen Wert von 0,7 V eingestellt, wie in Fig. 5A und Fig. 5B veranschaulicht, erkennt der Empfänger 122 auch bei einem Zustandswechsel von dem Zustand 401 auf den Zustand 402 bzw. von Dominant nach Rezessiv keine angeblichen Zustandswechsel mehr von dem Zustand 402 auf den Zustand 401 bzw. von Rezessiv nach Dominant, wie auch in Fig. 6A dargestellt. Somit kann eine Abtastung des Empfangssignals RxD bei dem derzeit üblichen Abtastpunkt AP sicher zu dem gewünschten Ergebnis führen, wie in Fig. 7A dargestellt. Dies gilt, auch wenn sich die Länge der Bitzeit tdom des Zustands 401 bzw. eines dominanten Bits gegenüber einer herkömmlichen Sende-/Empfangseinrichtung oder der Sende-/Empfangseinrichtung 13 der Teilnehmerstation 20 etwas verlängert, wie aus dem Vergleich von Fig. 7A und Fig. 7B ersichtlich.

Somit hat die Sende-/Empfangseinrichtung 12 gemäß dem vorliegenden Ausführungsbeispiel eine geringere Schwingneigung als eine herkömmliche Sende-/Empfangseinrichtung bzw. die Sende-/Empfangseinrichtung 13.

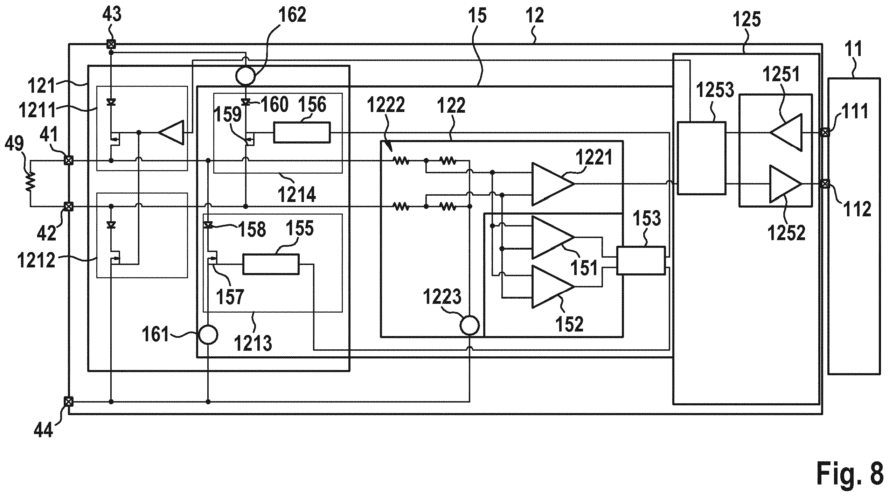

Im Betrieb der Sende-/Empfangseinrichtung 12 von Fig. 2 wird ein Wechsel des Buszustands 401 nach 402 bzw. von Dominant nach Rezessiv durch den Zustandswechsel-Erfassungsblock 151 erkannt, wenn bei dem TxD-Signal ein Rezessiv-Buszustand bzw. der Buszustand 401 mindestens für die Zeit eines Bits beginnt, wie in Fig. 3A veranschaulicht. Liegt gemäß der Ausgabe des Kommunikationsphasen-Erfassungsblocks 152 eine entsprechende Kommunikationsphase vor, steuert der RS-Zeitsteuerungsblock 153 von Fig. 2 den CAN_H_RS-Treiber 155 und/oder den CAN_L_RS-Treiber 156 an. Die Funktionsweise des Kommunikationsphasen-Erfassungsblocks 152 ist in Bezug auf Fig. 8 noch genauer beschrieben.

Als Folge der Ansteuerung des CAN_H_RS-Treibers 155 und/oder des CAN_L_RS-Treibers 156 schalten die Transistoren 157 und/oder 159. Die Ansteuerung des CAN_H_RS-Treibers 155 bewirkt beim Übergang des Buszustands 402 zum Buszustand 401 bzw. von Dominant nach Rezessiv eine Senkung der Ströme an der ersten Busader 41 bzw. der CAN_H-Leitung. Die Ansteuerung des CAN_L_RS-Treibers 156 bewirkt beim Übergang des Buszustands 402 zum Buszustand 401 bzw. von Dominant nach Rezessiv eine Erhöhung der Ströme bzw. ein Liefern von Strömen an der zweiten Busader 42 bzw. der CAN_L-Leitung. Somit wirkt die Treibernachbildung 1213 für CAN_H als Quelle. Im Unterschied dazu wirkt die Treibernachbildung 1214 für CAN_L als Senke.

Bei dem Beispiel eines CAN-Bussystems oder eines CAN-FD-Bussystems, würde nach dem Übergang des Buszustands 402 zum Buszustand 401 bzw. von Dominant nach Rezessiv das Signal CAN_L auf eine Spannung VDIFF - Vd bzw. Spannungswerte von 5 V - 0,65 V gezogen werden, wobei 5V der Wert der Differenzspannung VDIFF = CAN_H - CAN_L ist und für Vd als der Diodenflussspannung der Dioden 158, 160 ein Spannungswert von 0,65 V angenommen wurde. Das Signal CAN_H würde bei diesem Beispiel und einem Übergang des Buszustands von Dominant nach Rezessiv auf 0,65 V gezogen werden. Vorteilhaft ist hier, wenn der CAN_H_RS-Treiber 155 und/oder der CAN_L_RS-Treiber 156 nur solange angesteuert werden, dass die Signale CAN_H, CAN_L auf den Busadern 41, 42 noch in etwa bei der Sollspannung von VDIFF/2 liegen, also bei 2,5 V liegen. Sollte die differenziellen Busspannung VDIFF jedoch einen anderen Wert haben, wie beispielsweise, dass die Spannung VDIFF im rezessiven Zustand einen Spannungswert von beispielsweise -4 V haben darf, dann ist die Ansteuerung der Treiber 155, 156 zeitunkritisch.

Durch die Ansteuerung der Treibernachbildung 1213 wird ermöglicht, dass beim Übergang des Buszustands 402 zum Buszustand 401 bzw. von Dominant nach Rezessiv an der CAN_H Busader 41 auch Ströme gesenkt werden können. Durch die Ansteuerung der Treibernachbildung 1214 wird ermöglicht, dass beim Übergang des Buszustands 402 zum Buszustand 401 bzw. von Dominant nach Rezessiv an der CAN_L Busader 42 auch Ströme geliefert werden können.

Durch die beschriebene Ansteuerung der RS-Zeitsteuerungsblöcke 153, 154 wird eine im Schwingkreis vorhandene Energie abgebaut. Die RS-Zeitsteuerungsblöcke 153, 154 sind derart ausgestaltet, dass die Zeit der Ansteuerung der Senke und/oder Quelle in Bruchteilen der Bitzeit, vorzugsweise stufenlos, einstellbar ist. Somit ist auch die Zeit der Ansteuerung der der Treiber 155, 156 bzw. der Schalttransistoren 157, 159 in Bruchteilen der Bitzeit, vorzugsweise stufenlos, einstellbar. Die Einstellung kann entweder aufgrund einer Erfassung einer Erfassungseinrichtung im Betrieb der Sende-/Empfangseinrichtung 12 vorgenommen werden oder fest oder, insbesondere von einem Benutzer, konfigurierbar vorgegeben sein.

Die Ansteuerung wird abhängig von der Kommunikationsphase auf dem Bus 40 vorgenommen, wie zuvor angegeben.

Fig. 8 zeigt eine Sende-/Empfangseinrichtung 12A gemäß einer Modifikation des ersten Ausführungsbeispiels. Im Unterschied zu der Schaltung von Fig. 2 hat die Sende-/Empfangseinrichtung 12A von Fig. 8 zusätzlich zwei Spannungsquellen 161, 162. Die Spannungsquelle 161 ist in den Pfad zwischen dem Source-Anschluss des Transistors 157 und dem Anschluss 44 geschaltet. Die Spannungsquelle 162 ist in den Pfad zwischen der Anode der Diode 160 und dem Anschluss 43 geschaltet.

Die Spannungsquellen 161, 162 haben jeweils eine Spannung mit einem Wert, der sich aus einer Spannung am Anschluss 43 abzüglich einer Diodenflussspannung Vd ergibt. Bei dem Beispiel eines CAN-Bussystems oder eines CAN-FD-Bussystems würde also gelten V_CAN_SUPPLY/2 - Vd. Gemäß dem derzeitigen Standard würde der Wert 2,5 V - 0,65 V betragen, wenn die Dioden 158, 160 einen Spannungswert von 0.65V für die Diodenflussspannung Vd haben. Somit werden die Busadern 41, 42 auf 2.5V gezogen und man kann die Transistoren 157, 159 länger eingeschaltet lassen. In anderen Worten, die Treiber 155, 156 können die Transistoren 157, 159 länger ansteuern als zuvor in Bezug auf Fig. 2 für den derzeitigen Standard beschrieben. Somit ist die Ansteuerung der Treiber 155, 156 für den derzeitigen Standard bei dem genannten Beispiel weniger zeitkritisch als bisher.

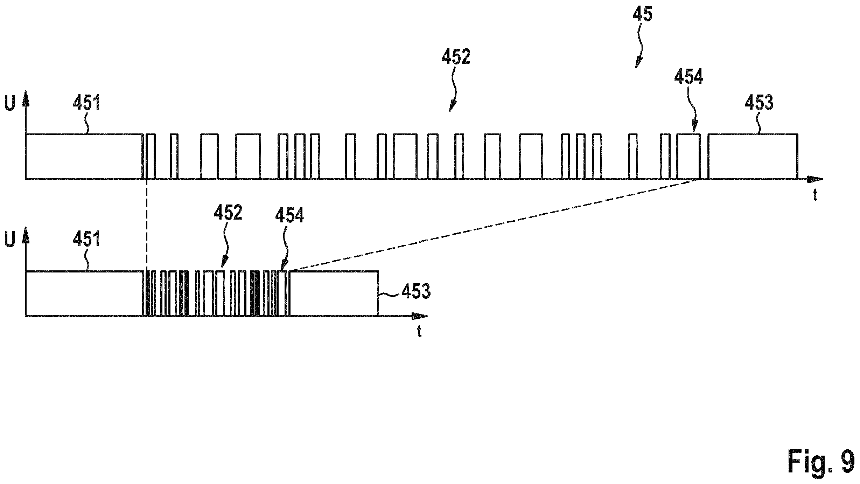

Fig. 9 stellt die unterschiedlichen Phasen einer Kommunikation auf dem Bus 40 dar, welche von dem Kommunikationsphasen-Erfassungsblock 152 erfasst und erkannt und unterschieden werden können. Fig. 9 zeigt in ihrem oberen Teil anhand der Nachricht 45 einen CAN-Rahmen, wie er von der Sende-/Empfangseinrichtung 12 oder der Sende-/Empfangseinrichtung 13 gesendet wird, und in ihrem unteren Teil einen CAN-FD-Rahmen, wie er von der Sende-/Empfangseinrichtung 12 gesendet werden kann. Der CAN-Rahmen und der CAN-FD-Rahmen sind für die CAN-Kommunikation auf dem Bus 40 grundlegend in zwei unterschiedliche Phasen unterteilt, nämlich die Arbitrationsphasen 451, 453 und einen Datenbereich 452, der bei CAN-HS auch Datenfeld bzw. bei CAN-FD auch Datenphase genannt wird. Der Datenbereich 452 ist an seinem Ende mit mindestens einem Endebit 454 abgeschlossen, das auch EOF genannt wird, wobei EOF für End of Frame bzw. Ende der Nachricht steht. Bei CAN oder CAN FD ist das EOF eine Bitabfolge aus 11 rezessiven Bits, also Bits mit dem zweiten Buszustand 402.

Bei CAN-FD wird im Vergleich zum klassischen CAN am Ende der Arbitrationsphase 451 die Bitrate für die folgende Datenphase auf z. B. 2, 4, 8Mbps erhöht. Damit gilt, dass bei CAN-FD die Bitrate in den Arbitrationsphasen 451, 453 kleiner als die Bitrate im Datenbereich 452 ist. Bei CAN-FD ist der Datenbereich 452 gegenüber dem Datenbereich 452 des CAN-Rahmens deutlich verkürzt.

Die Arbitrationsphasen 451, 453 sind ein wichtiger Bestandteil eines CAN-Rahmens und eines CAN-FD-Rahmens bzw. der Nachrichten 45, 46, 47, die in Fig. 1 gezeigt sind. Dabei wird entschieden, welcher Knoten bzw. welche Teilnehmerstation 10, 20, 30 des Bussystems 1 die wichtigste Nachricht 45, 46, 47 trägt. Die Teilnehmerstation 10, 20, 30 mit der wichtigsten Nachricht 45, 46, 47 gewinnt die Arbitration und darf daher die Nachricht nach Abschluss der Arbitrationsphase senden. Alle anderen Teilnehmerstationen sind dann beim Übertragen dieser wichtigsten Nachricht Zuhörer. Hierbei treiben die Sende-/Empfangseinrichtungen 12, 13 den Bus 40 niederohmig, um einen dominanten Buszustand 402 (Fig. 3A bis Fig. 7A) oder Bitzustand als einen der beiden verschiedenen Buszustände 401, 402 oder Bitzustände herzustellen. Im Rezessivzustand als dem anderen der beiden verschiedenen Buszustände 401, 402 dagegen sind die Sende-/Empfangseinrichtungen 12, 13 verhältnismäßig hochohmig.

Der Kommunikationsphasen-Erfassungsblock 152 kann die Arbitrationsphasen 451, 453, den Datenbereich 452 sowie das Ende des Datenbereichs 453, also das Endebit (EOF) 54 erkennen. Dadurch kann die Funktionalität der Schwingungsreduktionseinheit 150 je nach Wunsch entweder für alle Kommunikationsphasen 451 bis 453 oder Phasen/Bereiche einer Nachricht 45 gelten oder nur bei abgeschlossener Arbitration, also für den Datenbereich 452. Letzteres ist sinnvoll, wenn ansonsten zu viele Teilnehmerstationen 10, 20, 30 gleichzeitig beim Arbitrieren die Funktion der Sende-/Empfangseinrichtung 120 aktivieren können und damit den effektiven Buswiderstand zu stark reduzieren.

Somit wird mit der Sende-/Empfangseinrichtung 12 ein Verfahren zur Reduzierung einer Schwingneigung beim Übergang zwischen unterschiedlichen Bitzuständen durchgeführt.

Bei dem beschriebenen Ausführungsbeispiel haben nur die Teilnehmerstationen 10, 30 die Funktionalität der Sende-/Empfangseinrichtung 12. Die

Teilnehmerstationen 10, 30 sind vorzugsweise Teilnehmerstationen oder Knoten mit hoher Schwingneigung. Die hohe Schwingneigung der Teilnehmerstationen 10, 30 kann sich insbesondere durch deren Position im Bussystem 1, die Position der Terminationswiderstände 49, die Stub-Länge bzw. Stichleitungslänge zu den Teilnehmerstationen 10, 30, usw. ergeben.

Gemäß einer Modifikation des ersten Ausführungsbeispiels ist es gemäß einem vereinfachten Ansatz auch möglich, nur eine der beiden Treibernachbildungen 1213, 1214 für die Signale CAN_H oder CAN_L zu bedienen, um die Schwingungszeit nach dem Zustandswechsel von Dominant nach Rezessiv zu verkürzen. Dies bringt ebenfalls eine Verbesserung gegenüber einer herkömmlichen Sende-/Empfangseinrichtung oder der Sende-/Empfangseinrichtung 13 der Teilnehmerstation 20. In diesem Fall kann bei der Schaltung von Fig. 2 nur die Treibernachbildung 1213, 1214 für das zugehörige Signal CAN_H oder CAN_L vorhanden sein, das bedient werden soll.

Gemäß einer weiteren Modifikation des ersten Ausführungsbeispiels ist die zuvor beschriebene Funktionalität der Sende-/Empfangseinrichtung 12 nur aktiv, wenn die Sende-/Empfangseinrichtung 12 selbst sendet bzw. als Sender agiert.

Gemäß noch einer weiteren Modifikation des ersten Ausführungsbeispiels hat auch die Teilnehmerstation 20 anstelle einer Sende-/Empfangseinrichtung 13 eine Sende-/Empfangseinrichtung 12. In diesem Fall ist die zuvor beschriebene Funktionalität der Sende-/Empfangseinrichtung 12 für alle Teilnehmerstationen 10, 20, 30 des Bussystems aktiv, insbesondere je nach Bedarf. In diesem Fall wäre die Auswertung des Sendesignals TxD von Vorteil, so dass das Sendesignal TxD vom Anschluss 111 dem RS-Zeitsteuerungsblock 153 zugeführt wird.

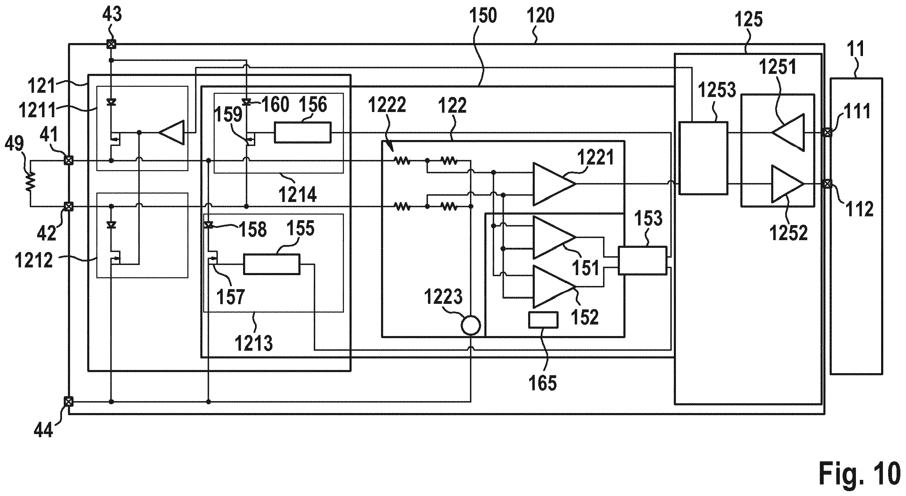

Fig. 10 zeigt den grundlegenden Aufbau einer Sende-/Empfangseinrichtung 120, die eine Schwingungsreduktionseinheit 150 aufweist. Das Bussystem 1 und die Sende-/Empfangseinrichtung 120 sind bis auf die nachfolgend beschriebenen Unterschiede auf die gleiche Weise aufgebaut, wie zuvor gemäß dem vorangehenden Ausführungsbeispiel oder seinen Modifikationen für das Bussystem 1 und die Sende-/Empfangseinrichtung 12 beschrieben.

Die Schwingungsreduktionseinheit 150 hat zusätzlich einen Phasenlage-Erfassungsblock 165. Der Phasenlage-Erfassungsblock 165 von Fig. 10 erfasst und bewertet die zeitliche Lage der Signale auf den beiden Busadern 41, 42 zueinander. Je nach Ergebnis steuert der Phasenlage-Erfassungsblock 165 die Treiber 155, 156 bzw. die Schalttransistoren 157, 159 über den RS-Zeitsteuerungsblock 153 an. Der Eingang des Phasenlage-Erfassungsblocks 165 kann ebenfalls parallel zu den Eingängen des Empfangskomparators 1221 geschaltet sein. Der Ausgang des Phasenlage-Erfassungsblocks 165 wird dem RS-Zeitsteuerungsblock 153 als weiterer Eingang zugeführt.

Somit kann ganz allgemein mit dem RS-Zeitsteuerungsblock 153 die Ansteuerung separat bzw. unabhängig voneinander für die Busadern 41, 42, insbesondere die Signale CAN_H und CAN_L, durchgeführt werden. Somit kann mit dem RS-Zeitsteuerungsblock 153 die Ansteuerung zeitlich getrennt für die Busadern 41, 42, insbesondere für die Signale CAN_H, CAN_L, durchgeführt werden. Dadurch kann sich die Phasenlage der Signale auf den beiden Busadern 41, 42 ändern. Wird auch noch das Erfassungsergebnis des Phasenlage-Erfassungsblocks 165 mit herangezogen, kann die Phasenlage der Signale auf den beiden Busadern 41, 42 ganz gezielt verändert werden. Infolgedessen wird die Dämpfung der Schwingung nach dem Zustandswechsel noch weiter beschleunigt.

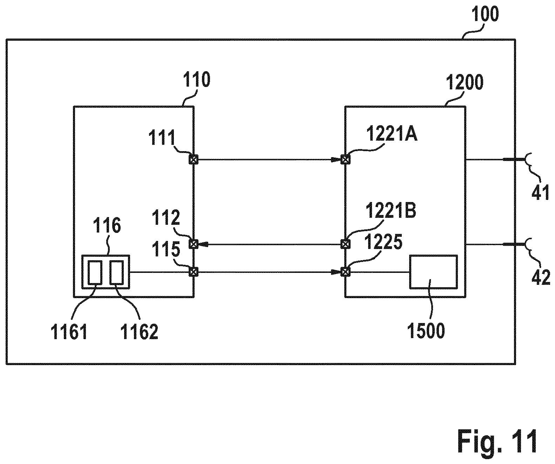

Fig. 11 zeigt den grundlegenden Aufbau einer Teilnehmerstation 100 mit einer Kommunikationssteuereinrichtung 110 und einer Sende-/Empfangseinrichtung 1200 gemäß einem dritten Ausführungsbeispiel. Das Bussystem 1 und die Teilnehmerstation 100 sind bis auf die nachfolgend beschriebenen Unterschiede auf die gleiche Weise aufgebaut, wie zuvor gemäß dem ersten Ausführungsbeispiel oder seinen Modifikationen für das Bussystem 1 und die Teilnehmerstation 10 beschrieben.

Die Kommunikationssteuereinrichtung 110 ist bis auf die nachfolgend beschriebenen Unterschiede aufgebaut wie die

Kommunikationssteuereinrichtung 11 des ersten Ausführungsbeispiels. Die Sende-/Empfangseinrichtung 1200 ist bis auf die nachfolgend beschriebenen Unterschiede aufgebaut wie die Sende-/Empfangseinrichtung 12 des ersten Ausführungsbeispiels.

Die Kommunikationssteuereinrichtung 110 hat neben den Anschlüssen 111, 112 für die Signale TxD, RxD einen zusätzlichen Anschluss 115 für ein Steuersignal RS_Control_Out.

Die Sende-/Empfangseinrichtung 1200 hat einen Anschluss 1221A zum Empfang des Sendesignals TxD von dem Anschluss 111 der Kommunikationssteuereinrichtung 110, wie bereits zuvor in Bezug auf das erste Ausführungsbeispiel allgemeiner beschrieben. Außerdem hat die Sende-/Empfangseinrichtung 1200 einen Anschluss 1221B zum Senden des Empfangssignals RxD an den Anschluss 112 der Kommunikationssteuereinrichtung 110, wie bereits zuvor in Bezug auf das erste Ausführungsbeispiel allgemeiner beschrieben. Zusätzlich dazu weist die Sende-/Empfangseinrichtung 1200 einen Anschluss 1225 auf, an welchem das Steuersignal RS_Control_Out als Steuersignal RS_Control_In empfangen wird.

Zur Erzeugung des Steuersignals RS_Control_Out für den Anschluss 115 hat die Kommunikationssteuereinrichtung 110 einen Steuerblock 116. Der Steuerblock 116 überwacht den Busverkehr auf den Busadern 41, 42, indem der Steuerblock 116 das als erste Informationen 1161 gespeicherte Sendesignal TxD und das am Anschluss 112 empfangene, und bei Bedarf zwischengespeicherte, Empfangssignal RxD miteinander vergleicht. Treten im rezessiven Buszustand, also dem ersten Buszustand 401, Abweichungen zwischen den beiden Signalen TxD, RxD auf, wie beispielsweise Zustandswechsel im Empfangssignal RxD, die nicht in dem Sendesignal TxD enthalten waren, so können daraus Rückschlüsse über das Netzwerk bzw. den Bus 40 und die Signalintegrität gezogen werden.

Des Weiteren liegen in dem Steuerblock 116 der Kommunikationssteuereinrichtung 110 zweite Informationen 1162 vor, wie Bitrate, Ausbreitungsverzögerung (Propagation-Delay) für beide Schaltvorgänge, also einem Zustandswechsel von dem ersten Buszustand 401 zu dem zweiten Buszustand 402. Die Informationen 1162 können alternativ in einem nicht dargestellten weiteren Block, insbesondere Speicher, vorgehalten werden.

Dabei kann der RxD-Ausgang am Anschluss 1221B anstelle eines Digitalsignals das Ausgangssignal eines Analog-Digital-Wandlers sein, welcher die Differenzspannung des Empfangssignals RxD darstellt.

Unter Berücksichtigung dieser Informationen 1161, 1162 erzeugt der Steuerblock 116 das Steuersignal RS_Control_Out, welches von dem Anschluss 115 ausgegeben wird, an dem Anschluss 1225 der Sende-/Empfangseinrichtung 1200 empfangen wird und an die Schwingungsreduktionseinheit 1500 weitergegeben wird. Dementsprechend können bei der Schwingungsreduktionseinheit 1500 die Blöcke 151, 152, 153 der Schwingungsreduktionseinheiten 15, 150 der vorangehenden Ausführungsbeispiele entfallen.

Auf diese Weise wird die Steuerung der Reduktion der Schwingneigung (Ringing Suppression) hier nicht von der Sende-/Empfangseinrichtung 1200 gesteuert, sondern von der Kommunikationssteuereinrichtung 110. Hierbei kann die Kommunikationssteuereinrichtung 110, genauer gesagt ihr Steuerblock 116, die Schwingungsreduktionseinheit 1500 an die speziellen Eigenschaften der Teilnehmerstation 100 und des Netzwerks bzw. des Busses 40 anpassen. In anderen Worten, die Kommunikationssteuereinrichtung 110, genauer gesagt ihr Steuerblock 116, kann die Schwingungsreduktionseinheit 1500 Knoten- und Netzwerk-Sensitiv einstellen. Der Steuerblock 116 bietet damit eine Lernfunktion für die Teilnehmerstation 100.

Damit kann ebenso eine deutliche Reduktion der Schwingneigung bei dem Zustandswechsel vom zweiten Buszustand 402 zum ersten Buszustand 401 realisiert werden. Zudem kann dadurch ein deutlicher Gewinn für das Bussystem 1 als Gesamtsystem erreicht werden.

Alle zuvor beschriebenen Ausgestaltungen der Schwingungsreduktionseinheiten 15, 150, 1500 der Sende-/Empfangseinrichtungen 12, 120, 1200 der Teilnehmerstationen 10, 20, 30, 100, des Bussystems 1 und des darin ausgeführten Verfahrens gemäß den Ausführungsbeispielen und deren Modifikationen können einzeln oder in allen möglichen Kombinationen Verwendung finden. Zusätzlich sind insbesondere folgende Modifikationen denkbar.

Das zuvor beschriebene Bussystem 1 gemäß den Ausführungsbeispielen und/oder deren Modifikationen ist anhand eines auf dem CAN-Protokoll basierenden Bussystems beschrieben. Das Bussystem 1 gemäß den Ausführungsbeispielen und/oder deren Modifikationen kann jedoch auch eine andere Art von Kommunikationsnetz sein. Es ist vorteilhaft, jedoch nicht zwangsläufige Voraussetzung, dass bei dem Bussystem 1 zumindest für bestimmte Zeitspannen ein exklusiver, kollisionsfreier Zugriff einer Teilnehmerstation 10, 20, 30,100 auf die Busleitung 40 oder einen gemeinsamen Kanal der Busleitung 40 gewährleistet ist.

Das Bussystem 1 gemäß den Ausführungsbeispielen und/oder deren Modifikationen ist insbesondere ein CAN-Netzwerk oder ein CAN-HS-Netzwerk oder ein CAN FD-Netzwerk oder ein FlexRay-Netzwerk. Das Bussystem 1 kann jedoch auch ein anderes serielles Kommunikationssetzwerk sein.

Insbesondere kann die Schwingungsreduktionseinheit 15, 150 bei LVDS (Low Voltage Differential Signaling) eingesetzt werden, der ein Schnittstellen-Standard für eine Hochgeschwindigkeits-Datenübertragung ist, bei welcher ein Sender und ein Empfänger über eine Datenübertragungsstrecke miteinander verbunden sind. LVDS ist standardisiert nach ANSI/TIA/EIA-644-1995.

Die Anzahl und Anordnung der Teilnehmerstationen 10, 20, 30, 100 in dem Bussystem 1 gemäß den Ausführungsbeispielen und/oder deren Modifikationen ist beliebig. Insbesondere können auch nur Teilnehmerstationen 10 oder Teilnehmerstationen 30 oder Teilnehmerstationen 100 in den Bussystemen 1 der Ausführungsbeispiele und/oder deren Modifikationen vorhanden sein.

Die Funktionalität der zuvor beschriebenen Ausführungsbeispiele und/oder deren Modifikationen lässt sich jeweils in einem Transceiver bzw. einer Sende-/Empfangseinrichtung 12 bzw. Transceiver oder einem CAN-Transceiver oder einem Transceiver-Chipsatz oder einem CAN-Transceiver-Chipsatz, usw. umsetzen. Zusätzlich oder alternativ kann es in existierende Produkte integriert werden. Insbesondere ist es möglich, dass die betrachtete Funktionalität entweder im Transceiver als separater elektronischer Baustein (Chip) realisiert oder in einer integrierten Gesamtlösung, bei welchem nur ein elektronischer Baustein (Chip) vorhanden ist, eingebettet ist.

## Patentansprüche

1. Bussystem (1), mit einem Bus (40) und mindestens zwei Teilnehmerstationen (10; 20; 30; 100), welche über den Bus (40) derart miteinander verbunden sind, dass sie miteinander kommunizieren können, wobei mindestens eine der mindestens zwei Teilnehmerstationen (10; 20; 30) aufweist:
eine Sende-/Empfangseinrichtung (12; 120; 1200), mit einem ersten Treiber (1211) zum Treiben eines Signals für eine erste Busader (41) eines Busses (40) des Bussystems (1), bei welchem Bussystem (1) zumindest zeitweise ein exklusiver, kollisionsfreier Zugriff einer Teilnehmerstation (10, 20, 30, 100) auf den Bus (40) des Bussystems (1) gewährleistet ist,
einem zweiten Treiber (1212) zum Treiben eines Signals für die zweite Busader (42) des Busses (40),
einer ersten Treibernachbildung (1213) zum Treiben eines Signals für die erste Busader (41), um für die erste Busader (41) von dem ersten Treiber (1211) gelieferte Ströme zu senken, und/oder
einer zweiten Treibernachbildung (1214) zum Treiben eines Signals für die zweite Busader (42), um zusätzlich zu dem zweiten Treiber (1212) für die zweite Busader (41) Ströme zu liefern,
einen Empfänger (122) zum Empfang eines Signals, das von einem Bus (40) des Bussystems (1) übertragen wird, und
einer Schwingungsreduktionseinheit (15; 150), die ausgestaltet ist, mindestens eine der Treibernachbildungen (1213, 1214) zum Treiben eines Signals für die erste und/oder zweite Busader (41, 42) anzusteuern, falls ein Zustandswechsel des empfangenen Signals von einem dominanten Buszustand (402) zu einem rezessiven Buszustand (401) erfasst wird;
**dadurch gekennzeichnet, dass** die mindestens eine der mindestens zwei Teilnehmerstationen aufweist:
eine Kommunikationssteuereinrichtung (110), weiche ausgestaltet ist, ein Signal (TxD) an die Sende-/Empfangseinrichtung (1200) zu senden, welches die Sende-/Empfangseinrichtung (1200) als Grundlage für die Signale (CAN_H, CAN_L) für die Busadern (41, 42) verwendet, und das Signal (TxD) mit einem von der Sende-/Empfangseinrichtung (1200) vom Bus (40) empfangenen Signal (RxD) zur Erzeugung eines Steuersignals zu vergleichen, wobei die Kommunikationssteuereinrichtung (110) ausgestaltet ist, das Steuersignal zur Steuerung der Schwingungsreduktionseinheit (1500) an die Sende-/Empfangseinrichtung (1200) auszugeben.

2. Bussystem (1) nach Anspruch 1,
wobei die erste Treibernachbildung (1213) einen Treiber (155), einen Transistor (157) und eine Diode (158) aufweist, deren Kathode mit einem Drain-Anschluss des Transistors (157) verbunden ist, und deren Anode mit der ersten Busader (41) verbunden ist,
wobei der Treiber (155) zum Ansteuern des Transistors (157) verschaltet ist, und
wobei ein Source-Anschluss des Transistors (157) mit Masse verbunden ist.

3. Bussystem (1) nach Anspruch 1 oder 2,
wobei die zweite Treibernachbildung (1214) einen Treiber (156), einen Transistor (159) und eine Diode (160) aufweist, deren Kathode mit einem Source-Anschluss des Transistors (157) verbunden ist, und deren Anode mit einer Spannungsversorgung für die erste und zweite Busader (41, 42) verbunden ist,
wobei der Treiber (156) zum Ansteuern des Transistors (159) verschaltet ist, und
wobei ein Drain-Anschluss des Transistors (157) mit der zweiten Busader (42) verbunden ist.

4. Bussystem (1) nach einem der vorangehenden Ansprüche, wobei die Schwingungsreduktionseinheit (15; 150) zudem aufweist
einen Erfassungsblock (151), welcher ausgestaltet ist, einen Zustandswechsel des empfangenen Signals von dem dominanten Buszustand (402) zu dem rezessiven Buszustand (401) zu erfassen, und dessen Eingang parallel zu einem Eingang eines Empfangskomparators der Sende-/Empfangseinrichtung (12; 120) geschaltet ist, und
einen RS-Zeitsteuerungsblock (153), der zum Steuern des Signals auf mindestens einer Busader (41; 42) in Abhängigkeit von dem Erfassungsergebnis des Erfassungsblocks (165) ausgestaltet ist.

5. Bussystem (1) nach Anspruch 4, wobei die Schwingungsreduktionseinheit (15; 150) zudem aufweist
einen Phasenlage-Erfassungsblock (165) zum Erfassen der zeitlichen Lage der Signale auf den Busadern (41, 42) des Busses (40) zueinander, und/oder
einen Kommunikationsphasen-Erfassungsblock (152) zum Erfassen von unterschiedlichen Phasen einer Kommunikation auf dem Bus (40),
wobei der RS-Zeitsteuerungsblock (153) zudem zum Steuern des Signals auf mindestens einer Busader (41; 42) in Abhängigkeit von dem Erfassungsergebnis des Phasenlage-Erfassungsblocks (165) ausgestaltet ist, um die Phasenlage des Signals auf der Busader (41; 42) einzustellen, und/oder zum Steuern des Signals auf mindestens einer Busader (41; 42) in Abhängigkeit von der erfassten Phase der Kommunikation auf dem Bus (40) zu steuern.

6. Bussystem (1) nach Anspruch 5, wobei der Kommunikationsphasen-Erfassungsblock (152) ausgestaltet ist, mindestens ein Endebit (454) zu erfassen, welches das Ende einer Nachricht (45; 47) anzeigt, um die unterschiedlichen Phasen einer Kommunikation auf dem Bus (40) zu erfassen.

7. Bussystem (1) nach Anspruch 5 oder 6, wobei der RS-Zeitsteuerungsblock (153) ausgestaltet ist, das Signal auf mindestens einer Busader (41; 42) nach Abschluss einer Arbitrationsphase (451; 453) der Kommunikation zu steuern.

8. Teilnehmerstation (10; 20; 30) für ein Bussystem (10), welche aufweist:
eine Sende-/Empfangseinrichtung (12; 120; 1200), mit einem ersten Treiber (1211) zum Treiben eines Signals für eine erste Busader (41) eines Busses (40) des Bussystems (1), bei welchem Bussystem (1) zumindest zeitweise ein exklusiver, kollisionsfreier Zugriff einer Teilnehmerstation (10, 20, 30, 100) auf den Bus (40) des Bussystems (1) gewährleistet ist,
einem zweiten Treiber (1212) zum Treiben eines Signals für die zweite Busader (42) des Busses (40),
einer ersten Treibernachbildung (1213) zum Treiben eines Signals für die erste Busader (41), um für die erste Busader (41) von dem ersten Treiber (1211) gelieferte Ströme zu senken, und/oder
einer zweiten Treibernachbildung (1214) zum Treiben eines Signals für die zweite Busader (42), um zusätzlich zu dem zweiten Treiber (1212) für die zweite Busader (41) Ströme zu liefern,
einen Empfänger (122) zum Empfang eines Signals, das von einem Bus (40) des Bussystems (1) übertragen wird, und
einer Schwingungsreduktionseinheit (15; 150), die ausgestaltet ist, mindestens eine der Treibernachbildungen (1213, 1214) zum Treiben eines Signals für die erste und/oder zweite Busader (41, 42) anzusteuern, falls ein Zustandswechsel des empfangenen Signals von einem dominanten Buszustand (402) zu einem rezessiven Buszustand (401) erfasst wird;
**dadurch gekennzeichnet, dass** die Teilnehmerstation aufweist:
eine Kommunikationssteuereinrichtung (110), welche ausgestaltet ist, ein Signal (TxD) an die Sende-/Empfangseinrichtung (1200) zu senden, welches die Sende-/Empfangseinrichtung (1200) als Grundlage für die Signale (CAN_H, CAN_L) für die Busadern (41, 42) verwendet, und das Signal (TxD) mit einem von der Sende-/Empfangseinrichtung (1200) vom Bus (40) empfangenen Signal (RxD) zur Erzeugung eines Steuersignals zu vergleichen, wobei die Kommunikationssteuereinrichtung (110) ausgestaltet ist, das Steuersignal zur Steuerung der Schwingungsreduktionseinheit (1500) an die Sende-/Empfangseinrichtung (1200) auszugeben.

## Claims

1. Bus system (1) having a bus (40) and at least two subscriber stations (10; 20; 30; 100) that are connected to one another via the bus (40) such that they can communicate with one another, wherein at least one of the at least two subscriber stations (10; 20; 30) has:
a transmission/reception device (12; 120; 1200) having a first driver (1211) for driving a signal for a first bus wire (41) of a bus (40) of the bus system (1), which bus system (1) exhibits at least intermittently ensured exclusive collision-free access by a subscriber station (10, 20, 30, 100) to the bus (40) of the bus system (1),
a second driver (1212) for driving a signal for the second bus wire (42) of the bus (40),
a first driver reproduction (1213) for driving a signal for the first bus wire (41), in order to lower currents delivered for the first bus wire (41) by the first driver (1211), and/or
a second driver reproduction (1214) for driving a signal for the second bus wire (42), in order to deliver currents for the second bus wire (41) in addition to the second driver (1212),
a receiver (122) for receiving a signal transmitted by a bus (40) of the bus system (1), and
an oscillation reduction unit (15; 150) configured to actuate at least one of the driver reproductions (1213, 1214) to drive a signal for the first and/or second bus wire (41, 42) if a change of state of the received signal from a dominant bus state (402) to a recessive bus state (401) is detected;
**characterized in that** the at least one of the at least two subscriber stations has:
a communication control device (110) configured to transmit a signal (TxD) to the transmission/reception device (1200), which signal is used by the transmission/reception device (1200) as a basis for the signals (CAN_H, CAN_L) for the bus wires (41, 42), and to compare the signal (TxD) with a signal (RxD) received by the transmission/reception device (1200) from the bus (40) in order to generate a control signal, wherein the communication control device (110) is configured to output the control signal to the transmission/reception device (1200) in order to control the oscillation reduction unit (1500).

2. Bus system (1) according to Claim 1,
wherein the first driver reproduction (1213) has a driver (155), a transistor (157) and a diode (158), the cathode of which is connected to a drain connection of the transistor (157) and the anode of which is connected to the first bus wire (41),
wherein the driver (155) is connected up to actuate the transistor (157), and
wherein a source connection of the transistor (157) is connected to earth.

3. Bus system (1) according to Claim 1 or 2,
wherein the second driver reproduction (1214) has a driver (156), a transistor (159) and a diode (160), the cathode of which is connected to a source connection of the transistor (157) and the anode of which is connected to a voltage supply for the first and second bus wires (41, 42),
wherein the driver (156) is connected up to actuate the transistor (159), and
wherein a drain connection of the transistor (157) is connected to the second bus wire (42).

4. Bus system (1) according to one of the preceding claims, wherein the oscillation reduction unit (15; 150) also has
a detection block (151) configured to detect a change of state of the received signal from the dominant bus state (402) to the recessive bus state (401), the input of which detection block is connected in parallel with an input of a reception comparator of the transmission/reception device (12; 120), and
an RS timing block (153) configured to control the signal on at least one bus wire (41; 42) on the basis of the detection result of the detection block (165).

5. Bus system (1) according to Claim 4, wherein the oscillation reduction unit (15; 150) also has
a phase angle detection block (165) for detecting the temporal position of the signals on the bus wires (41, 42) of the bus (40) in relation to one another, and/or
a communication phase detection block (152) for detecting different phases of a communication on the bus (40),
wherein the RS timing block (153) is also configured to control the signal on at least one bus wire (41; 42) on the basis of the detection result of the phase angle detection block (165), in order to set the phase angle of the signal on the bus wire (41; 42), and/or to control the signal on at least one bus wire (41; 42) on the basis of the detected phase of the communication on the bus (40).

6. Bus system (1) according to Claim 5, wherein the communication phase detection block (152) is configured to detect at least one end bit (454) that indicates the end of a message (45; 47), in order to detect the different phases of a communication on the bus (40).

7. Bus system (1) according to Claim 5 or 6, wherein the RS timing block (153) is configured to control the signal on at least one bus wire (41; 42) following the conclusion of an arbitration phase (451; 453) of the communication.

8. Subscriber station (10; 20; 30) for a bus system (10), having:
a transmission/reception device (12; 120; 1200) having a first driver (1211) for driving a signal for a first bus wire (41) of a bus (40) of the bus system (1), which bus system (1) exhibits at least intermittently ensured exclusive collision-free access by a subscriber station (10, 20, 30, 100) to the bus (40) of the bus system (1),
a second driver (1212) for driving a signal for the second bus wire (42) of the bus (40),
a first driver reproduction (1213) for driving a signal for the first bus wire (41), in order to lower currents delivered for the first bus wire (41) by the first driver (1211), and/or
a second driver reproduction (1214) for driving a signal for the second bus wire (42), in order to deliver currents for the second bus wire (41) in addition to the second driver (1212),
a receiver (122) for receiving a signal transmitted by a bus (40) of the bus system (1), and
an oscillation reduction unit (15; 150) configured to actuate at least one of the driver reproductions (1213, 1214) to drive a signal for the first and/or second bus wire (41, 42) if a change of state of the received signal from a dominant bus state (402) to a recessive bus state (401) is detected;
**characterized in that** the subscriber station has:
a communication control device (110) configured to transmit a signal (TxD) to the transmission/reception device (1200), which signal is used by the transmission/reception device (1200) as a basis for the signals (CAN_H, CAN_L) for the bus wires (41, 42), and to compare the signal (TxD) with a signal (RxD) received by the transmission/reception device (1200) from the bus (40) in order to generate a control signal, wherein the communication control device (110) is configured to output the control signal to the transmission/reception device (1200) in order to control the oscillation reduction unit (1500).

## Revendications

1. Système de bus (1), comprenant un bus (40) et au moins deux stations d'abonnés (10 ; 20 ; 30 ; 100) qui sont reliées entre elles par l'intermédiaire du bus (40) de manière à pouvoir communiquer entre elles, dans lequel au moins l'une desdites au moins deux stations d'abonnés (10 ; 20 ; 30) comporte :
un dispositif d'émission-réception (12 ; 120 ; 1200), comprenant
un premier pilote (1211), destiné à piloter un signal pour un premier conducteur de bus (41) d'un bus (40) du système de bus (1), un accès exclusif, sans collision, à une station d'abonné (10, 20, 30, 100) au bus (40) du système de bus (1) étant assuré au moins temporairement dans ledit système de bus (1),
un deuxième pilote (1212), destiné à piloter un signal pour le deuxième conducteur de bus (42) du bus (40), une première réplique de pilote (1213), destinée à piloter un signal pour le premier conducteur de bus (41), afin de réduire des courants fournis au premier conducteur de bus (41) par le premier pilote (1211), et/ou
une deuxième réplique de pilote (1214), destinée à piloter un signal pour le deuxième conducteur de bus (42), afin de fournir en complément des courants au deuxième pilote (1212) pour le deuxième conducteur de bus (41), un récepteur (122), destiné à recevoir un signal, qui est transmis par un bus (40) du système de bus (1), et
une unité de réduction d'oscillations (15; 150), laquelle est conçue pour piloter au moins l'une des répliques de pilote (1213, 1214) pour piloter un signal pour les premier et/ou deuxième conducteurs de bus (41, 42) dans le cas où une transition d'état du signal reçu, d'un état de bus dominant (402) à un état de bus récessif (401), est détectée ;
**caractérisé en ce que** ladite au moins une desdites au moins deux stations d'abonnés comporte :
un dispositif de commande de communication (110), lequel est conçu pour émettre un signal (TxD) vers le dispositif d'émission/réception (1200), que le dispositif d'émission/réception (1200) utilise comme base pour les signaux (CAN_H, CAN_L) pour les conducteurs de bus (41, 42), et pour comparer le signal (TxD) à un signal (RxD) reçu par le dispositif d'émission/réception (1200) en provenance du bus (40) pour générer un signal de commande, dans lequel le dispositif de commande de communication (110) est conçu pour fournir le signal de commande au dispositif d'émission/réception (1200) pour commander l'unité de réduction d'oscillations (1500).

2. Système de bus (1) selon la revendication 1,
dans lequel la première réplique de pilote (1213) comporte un pilote (155), un transistor (157) et une diode (158) dont la cathode est reliée à une borne de drain du transistor (157) et dont l'anode est reliée au premier conducteur de bus (41),
dans lequel le pilote (155) est connecté de manière à commander le transistor (157), et
dans lequel une borne de source du transistor (157) est reliée à la masse.

3. Système de bus (1) selon la revendication 1 ou 2,
dans lequel la deuxième réplique de pilote (1214) comporte un pilote (156), un transistor (159) et une diode (160) dont la cathode est reliée à une borne de source du transistor (157) et dont l'anode est reliée à une alimentation en tension pour les premier et deuxième conducteurs de bus (41, 42),
dans lequel le pilote (156) est connecté de manière à commander le transistor (159), et
dans lequel une borne de drain du transistor (157) est reliée au deuxième conducteur de bus (42).

4. Système de bus (1) selon l'une quelconque des revendications précédentes, dans lequel l'unité de réduction d'oscillations (15 ; 150) comporte en outre un bloc de détection (151), lequel est conçu pour détecter une transition d'état du signal reçu de l'état de bus dominant (402) à l'état de bus récessif (401), et dont l'entrée est connectée en parallèle à une entrée d'un comparateur de réception du dispositif d'émission/réception (12; 120), et un bloc de synchronisation RS (153), lequel est conçu pour commander le signal sur au moins un conducteur de bus (41 ; 42) en fonction du résultat de détection du bloc de détection (165).

5. Système de bus (1) selon la revendication 4, dans lequel l'unité de réduction d'oscillations (15 ; 150) comporte en outre
un bloc de détection de position de phase (165), destiné à détecter la position temporelle, les uns par rapport aux autres, des signaux sur les conducteurs de bus (41, 42) du bus (40), et/ou
un bloc de détection de phase de communication (152), destiné à détecter différentes phases d'une communication sur le bus (40),
dans lequel le bloc de synchronisation RS (153) est en outre conçu pour commander le signal sur au moins un conducteur de bus (41 ; 42) en fonction du résultat de détection du bloc de détection de phase (165) afin de régler la phase du signal sur le conducteur de bus (41 ; 42), et/ou
pour commander le signal sur au moins un conducteur de bus (41 ; 42) en fonction de la phase détectée de la communication sur le bus (40).

6. Système de bus (1) selon la revendication 5, dans lequel le bloc de détection de phase de communication (152) est conçu pour détecter au moins un bit de fin (454), lequel indique la fin d'un message (45 ; 47), afin de détecter les différentes phases d'une communication sur le bus (40).

7. Système de bus (1) selon la revendication 5 ou 6, dans lequel le bloc de synchronisation RS (153) est conçu pour commander le signal sur au moins un conducteur de bus (41 ; 42) après l'achèvement d'une phase d'arbitrage (451 ; 453) de la communication.

8. Station d'abonné (10; 20; 30) destinée à un système de bus (10), laquelle comporte :
un dispositif d'émission/réception (12 ; 120 ; 1200), comprenant
un premier pilote (1211), destiné à piloter un signal pour un premier conducteur de bus (41) d'un bus (40) du système de bus (1), un accès exclusif, sans collision, à une station d'abonné (10, 20, 30, 100) au bus (40) du système de bus (1) étant assuré au moins temporairement dans ledit système de bus (1),
un deuxième pilote (1212), destiné à piloter un signal pour le deuxième conducteur de bus (42) du bus (40), une première réplique de pilote (1213), destinée à piloter un signal pour le premier conducteur de bus (41), afin de réduire des courants fournis au premier conducteur de bus (41) par le premier pilote (1211), et/ou
une deuxième réplique de pilote (1214), destinée à piloter un signal pour le deuxième conducteur de bus (42), afin de fournir en complément des courants au deuxième pilote (1212) pour le deuxième conducteur de bus (41), un récepteur (122), destiné à recevoir un signal, qui est transmis par un bus (40) du système de bus (1), et
une unité de réduction d'oscillations (15; 150), laquelle est conçue pour piloter au moins l'une des répliques de pilote (1213, 1214) pour piloter un signal pour les premier et/ou deuxième conducteurs de bus (41, 42) dans le cas où une transition d'état du signal reçu, d'un état de bus dominant (402) à un état de bus récessif (401), est détectée ;
**caractérisée en ce que** la station d'abonné comporte :
un dispositif de commande de communication (110), lequel est conçu pour émettre un signal (TxD) vers le dispositif d'émission/réception (1200), que le dispositif d'émission/réception (1200) utilise comme base pour les signaux (CAN_H, CAN_L) pour les conducteurs de bus (41, 42), et pour comparer le signal (TxD) à un signal (RxD) reçu par le dispositif d'émission/réception (1200) en provenance du bus (40) pour générer un signal de commande, dans lequel le dispositif de commande de communication (110) est conçu pour fournir le signal de commande au dispositif d'émission/réception (1200) pour commander l'unité de réduction d'oscillations (1500).
